# EUROPEAN PATENT SPECIFICATION

(11) **EP 0 642 154 B1**
(45) Date of publication and mention of the grant of the patent: **04.03.1998**
(21) Application number: 94306340.4
(22) Date of filing: 30.08.1994
(51) Int. Cl.: H01L 21/20, C30B 25/02

(54) **Process for producing group III-V compound semiconductor and group III-V compound semiconductor**
Verfahren zum Herstellen eines III-V-Halbleitermaterials und ein III-V-Halbleitermaterial
Procédé de production d'un matériau semi-conducteur des groupes III à V, et matériau semi-conducteur des groupes III à V

(30) Priority: 03.09.1993 JP 220140/93; 03.09.1993 JP 220141/93
(43) Date of publication of application: 08.03.1995
(73) Proprietor: Mitsubishi Chemical Corporation, Chiyoda-ku Tokyo (JP)
(72) Inventor: Hosoi, Nobuyuki, Tsuchiura-shi, Ibaraki-ken (JP); Shimoyama, Kenji, Tsuchiura-shi, Ibaraki-ken (JP); Goto, Hideki, Tsuchiura-shi, Ibaraki-ken (JP)
(74) Representative: Woods, Geoffrey Corlett

(56) References cited:
- EP-A- 0 325 275
- DE-A- 3 527 269
- US-A- 5 016 252

## Description

The present invention relates to a process for producing a Group III-V compound semiconductor and to a Group III-V compound semiconductor. These semiconductors may be used for various semiconductor devices such as laser diodes, light-emitting diodes and high electron-mobility transistors.

The following methods have been known for crystal growth of the elements used for semiconductor devices: (i) a crystal of C₁^{III}AsₓP₁₋ₓ (C₁^{III}: one or more Group III elements, 0 ≤ x < 0.5) is directly grown on A₁^{III}As_{w}P_{1-w} (A₁^{III}: one or more Group III elements with an Al content of less than 0.3, 0.5 < w ≤ 1) formed on a semiconductor crystal substrate or on an epitaxial film grown on said substrate; and (ii) a crystal of A₂^{III}AsᵤP₁₋ᵤ (A₂^{III}: one or more Group III elements with an In content of not less than 0.3, 0 ≤ u ≤ 1) is grown on a semiconductor crystal substrate or on an epitaxial film grown on said substrate, and after an interruption of crystal growth in which a heating step is required, a C₂^{III}As_{z}P_{1-z} crystal (C₂^{III}: one or more Group III elements, 0 ≤ z ≤ 1) is grown directly on the A₂^{III}AsᵤP₁₋ᵤ.

For crystal growth of (Al_{y}Ga_{1-y})_{0.5}In_{0.5}P (0 ≤ y ≤ 1), which is a material used in visible laser diodes or visible light emitting diodes, a GaAs buffer layer is generally grown on a GaAs substrate and the crystal material is directly grown on the GaAs buffer layer by a MOVPE (metal organic vapor phase epitaxy) technique.

However, the direct growth of a (Al_{y}Ga_{1-y})_{0.5}In_{0.5}P crystal on the GaAs buffer layer formed on a GaAs substrate involves problems in that substitution takes place between the As in the GaAs crystal and the P in the vapor phase causing interfacial defects, thereby making it impossible to obtain an AlGaInP crystal with a good quality. Especially in the growth of an AlGaInP crystal with a high Al content, it is vital to carry out the crystal growth at a high temperature (not less than 700°C) for preventing contamination of the crystal with oxygen, to reduce the influence of the interfacial defects due to substitution between the As in the GaAs crystal and the P in the vapor phase.

Growth of the GaAs buffer layer on a semiconductor substrate is preferably carried out at a low temperature of less than 700°C for minimizing diffusion of impurities from the substrate crystal into the epitaxial crystal layer. Further, if the buffer layer of A₂^{III}AsᵤP₁₋ᵤ has a high In content, when the crystal growth is carried out at a high temperature a large quantity of In has to be supplied since the efficiency of In incorporation into the crystal is reduced. Thus, it is advantageous to carry out the crystal growth of the A₂^{III}AsᵤP₁₋ᵤ buffer layer at a low temperature (less than 700°C).

On the other hand, the light-emitting layer of a light-emitting semiconductor device needs to have a high luminous efficiency as well as a good crystal quality. Therefore, it is generally preferred that the growth of the light-emitting layer is carried out at a high temperature. Especially in the case where the light-emitting layer contains Al (for example, a layer composed of AlGaInP or AlGaAs), when the crystal growth is carried out at a low temperature (less than 700°C), the Al element which is one of components of the layer, reacts with the oxygen remaining in a trace amount in the growth gas. This causes contamination of the crystal with the oxides or occurrence of micro-defects, so that it is impossible to obtain a crystal with a high luminous efficiency and a good quality. Therefore, it is preferred that the growth of AlGaInP or AlGaAs is carried out at a high temperature (not less than 700°C) so as to prevent the grown crystal from being contaminated with the Al and oxygen reaction product.

For these reasons, in the crystal growth method in which a A₂^{III}AsᵤP₁₋ᵤ crystal is first grown on a substrate and then a AlGaInP or AlGaAs crystal is grown on the A₂^{III}AsᵤP₁₋ᵤ buffer layer, it is usual practice to carry out the growth of the A₂^{III}AsᵤP₁₋ᵤ crystal at a low temperature (around 660°C) and then elevate the temperature to conduct the growth of the AlGaInP or AlGaAs crystal at a high temperature of not less than 700°C.

In this method, however, a part of the In in the A₂^{III}AsᵤP₁₋ᵤ crystal grown at a low temperature is desorbed in the course of heating due to the high vapor pressure, thereby causing surface defects in the grown crystal. The AlGaInP or AlGaAs crystal grown thereon inherits these defects, so that it is impossible to obtain the desired high-quality AlGaInP or AlGaAs crystal.

The present invention seeks to provide a semiconductor having a thin crystal film of C₁^{III}AsₓP₁₋ₓ or C₂^{III}As_{z}P_{1-z} which is substantially free of contamination with impurities or micro-defects.

The present invention seeks to provide a high-reliability and high-performance semiconductor device using said crystal film.

As a result of intensive studies for overcoming these technical problems, it has been found that by growing a thin crystal film of B^{III}As (B^{III}: one or more Group III elements with an Al content of not less than 0.3) as a protective film on a thin film of A₁^{III}As_{w}P_{1-w} or A₂^{III}AsᵤP₁₋ᵤ formed on a semiconductor crystal substrate or on an epitaxial layer grown on the semiconductor crystal substrate, it is possible to prevent said interfacial defects, especially the crystal defects caused in the heating step, and to obtain a good crystal lattice-matched to the underlying layer.

The present invention provides a process for producing a Group III-V compound semiconductor, which comprises:
(1) forming a thin crystal film of A₁^{III}As_{w}P_{1-w}, wherein A₁^{III} represents one or more Group III elements with an Al content of less than 0.3, and 0.5 < w ≤ 1, on a semiconductor crystal substrate or on an epitaxial film grown on said substrate;
   forming thereon a thin crystal film of B^{III}As, wherein B^{III} represents one or more Group III elements with an Al content of not less than 0.3, and
   forming thereon a thin crystal film of C₁^{III}AsₓP₁₋ₓ, wherein C₁^{III} represents one or more Group III elements with an Al content of less than 0.3, and 0 ≤ x < 0.5; or
(2) forming a thin crystal film of A₂^{III}AsᵤP₁₋ᵤ, wherein A₂^{III} represents one or more Group III elements with an In content of not less than 0.3, and 0 ≤ u ≤ 1, on a semiconductor crystal substrate or on an epitaxial film grown on said substrate;
   forming thereon a thin crystal film of B^{III}As, wherein B^{III} represents one or more Group III elements with an Al content of not less than 0.3; and
   forming thereon a thin crystal film of C₂^{III}As_{z}P_{1-z,} wherein C₂^{III} represents Group III elements and 0 ≤ z ≤ 1.

The present invention also provides a Group III-V compound semiconductor comprising:
(1) a thin crystal film of A₁^{III}As_{w}P_{1-w,} wherein A₁^{III} represents one or more Group III elements with an Al content of less than 0.3, and 0.5 < w ≤ 1, formed on a semiconductor crystal substrate or on an epitaxial film grown on said substrate;
   a thin crystal film of B^{III}As, wherein B^{III} represents one or more Group III elements with an Al content of not less than 0.3, formed on the A₁^{III}As_{w}P_{1-w} film; and
   a thin film of C₁^{III}AsₓP₁₋ₓ, wherein C₁^{III} represents one or more Group III elements with an Al content of less than 0.3, and 0 ≤ x < 0.5, formed on the B^{III}As film; or
(2) a thin film of A₂^{III}AsᵤP₁₋ᵤ, wherein A₂^{III} represents one or more Group III elements with an In content of not less than 0.3, and 0 ≤ u ≤ 1, formed on a semiconductor crystal substrate or on an epitaxial film grown on said substrate;
   a thin crystal film of B^{III}As, wherein B^{III} represents one or more Group III elements with an Al content of not less than 0.3, formed on the A₂^{III}AsᵤP₁₋ᵤ film; and
   a thin film of C₂^{III}As_{z}P_{1-z}, wherein C₂^{III} represents one or more Group III elements and 0 ≤ z ≤ 1, formed on the B^{III}As film.

The present invention additionally provides a Group III-V compound semiconductor as defined above which is obtainable by the process defined above.

The present invention further provides a laser diode, light-emitting diode or transistor comprising a semiconductor as defined above.

Fig. 1 is a schematic illustration of the structure of the semiconductor of Example 1 fabricated according to the process of the present invention.

Fig. 2 is a schematic illustration of the structure of the semiconductor of Example 2 fabricated according to the process of the present invention.

In the present invention, a thin crystal film of A₂^{III}AsᵤP₁₋ᵤ is formed on a semiconductor crystal substrate or on an epitaxial layer grown on the semiconductor crystal substrate, preferably at a temperature of less than 700°C, more preferably 600 to 680°C, for the reason mentioned above.

Examples of A₁^{III}As_{w}P_{1-w} usable in present invention which contain one or more Group III elements with an Al content of less than 0.3 include InAsP, AlInAsP, AlInAs, InAs, AlGaAs, GaAs and GaAsP.

Examples of A₂^{III}AsᵤP₁₋ᵤ which contain one or more Group III elements with an In content of not less than 0.3 include InAsP, AlInAsP, AlInAs, InAs, AlInP, GaInP, AlGaInP, InGaAs and InGaAsP.

The thickness of each thin crystal film of A₁^{III}As_{w}P_{1-w} and A₂^{III}AsᵤP₁₋ᵤ depends on the purpose of use of the thin crystal film. In case it is used as a buffer layer, the thickness of each film is preferably from 0.1 to 2 µm.

The semiconductor crystal substrate or the epitaxial layer grown on the substrate used in the present invention is preferably one which has no possibility of causing a lattice mismatch between the A₁^{III}As_{w}P_{1-w} or A₂^{III}AsᵤP₁₋ᵤ layer and the semiconductor crystal substrate or the epitaxial layer grown thereon. More preferably, the substrate or the epitaxial layer grown thereon is of the same composition as the A₁^{III}As_{w}P_{1-w} or A₂^{III}AsᵤP₁₋ᵤ layer.

The thickness of the semiconductor crystal substrate depends on the purpose of use thereof, but is preferably from 100 to 500 µm.

The thin crystal film of B^{III}As used in the present invention serves as a protective layer for inhibiting substitution between the As in the underlying layer of A₁^{III}As_{w}P_{1-w} crystal and the P in the vapor phase or desorption of In in the A₂^{III}AsᵤP₁₋ᵤ crystal layer. The lower limit of thickness of the B^{III}As crystal film is 0.5 nm, preferably 2 nm, in the case of a AlAs crystal film.

Since the B^{III}As crystal film acts as a protective layer in spite of its small thickness such as mentioned above, application of this B^{III}As layer does not substantially influence the electrical and optical properties of the product. The upper limit of thickness of the B^{III}As crystal film can be raised to a level close to the critical thickness which does not cause dislocation due to lattice mismatch, but for economic reasons the upper limit of the thickness of the B^{III}As crystal film is 10 µm. Thus, the film thickness is from 0.5 nm to 10 µm, preferably from 2 nm to 5 µm, more preferably 5 nm to 2 µm. The thin film of B^{III}As is grown at the same temperature as that used for its underlying layer so that there is no desorption of a part of As or In from the underlying layer of the A₁^{III}As_{w}P_{1-w} or A₂^{III}AsᵤP₁₋ᵤ crystal during the growth to cause surface defects.

AlGaAs and AlAs can be mentioned as typical examples of B^{III}As. The Al content in the Group III elements in B^{III}As is not less than 0.3, preferably not less than 0.45. For producing a salient effect, the Al content is preferably not less than 0.55, and in the case where the film thickness is reduced, the content is preferably not less than 0.7.

When growing C₁^{III}AsₓP₁₋ₓ of a desired composition on the B^{III}As layer, there can be obtained a C₁^{III}AsₓP₁₋ₓ layer with a very good crystal quality.

Growth of C₂^{III}As_{z}P_{1-z} on the B^{III}As layer is carried out at a higher temperature than conventionally used in the case where Al is contained, such as in a AlGaInP or AlGaAs crystal, for the reasons mentioned above.

Even when the growth of C₂^{III}As_{z}P_{1-z} is carried out at the same temperature as used for the underlying layer, when the crystal growth is interrupted for some reason or other before the C₂^{III}As_{z}P_{1-z} crystal is grown, the B^{III}As protective layer proves effective for preventing desorption of the In.

The crystal growth mentioned above can be accomplished by a known MOVPE (metal organic vapor phase epitaxy) or MOMBE (metal organic molecular beam epitaxy) technique. It is also possible to employ other known methods such as a VPE (vapor phase epitaxy) or MBE (molecular beam epitaxy) technique.

In the crystal growth process according to the present invention, it is possible to prevent desorption of the In from the underlying layer even under high temperatures owing to the application of a thin crystal film of B^{III}As which is grown as an underlying layer before the growth of the C₁^{III}AsₓP₁₋ₓ or C₂^{III}As_{z}P_{1-z} crystal. Also, since As is scarcely desorbed because of the high Al-As bond energy, the B^{III}As, film surface remains free of defects during the heating step. Therefore, even when growth of the C₁^{III}AsₓP₁₋ₓ or C₂^{III}As_{z}P_{1-z} crystal is carried out at a high temperature on the A₁^{III}As_{w}P_{1-w} or A₂^{III}AsᵤP₁₋ᵤ crystal of the buffer layer having its surface protected with a B^{III}As film, no defect, such as seen in the conventional practice, is induced, and a high-quality crystal well reflecting the growth effect at a high temperature can be obtained.

Even when growth of C₂^{III}As_{z}P_{1-z} is performed at the same temperature as used for the growth of its underlying layer, when it is necessary to interrupt the crystal growth for some reason or other, the B^{III}As layer proves to be very useful for preventing trouble.

The above-described crystal growth process is particularly effective when the substrate crystal is GaAs, GaP, InP or an alloy semiconductor thereof, and an equal effect can be obtained in each case.

According to the process of the present invention, substitution between the As in the crystal of A₁^{III}As_{w}P_{1-w} on a semiconductor substrate and the P in the vapor phase is inhibited which prevents occurrence of interfacial defects. The thus grown C₁^{III}AsₓP₁₋ₓ crystal is substantially free of impurities or micro-defects and can therefore serve as a high-quality crystal with a strong photoluminescence intensity.

It is also possible to grow the crystal of AlGaInP or AlGaAs at an optimal temperature higher than used for forming a buffer layer on a semiconductor substrate. The thus grown AlGaInP or AlGaAs crystal has few impurities or micro-defects and can serve as a high-quality crystal with a strong photoluminescence intensity.

### Examples

The present invention is now further described in the following Examples thereof.

### Example 1

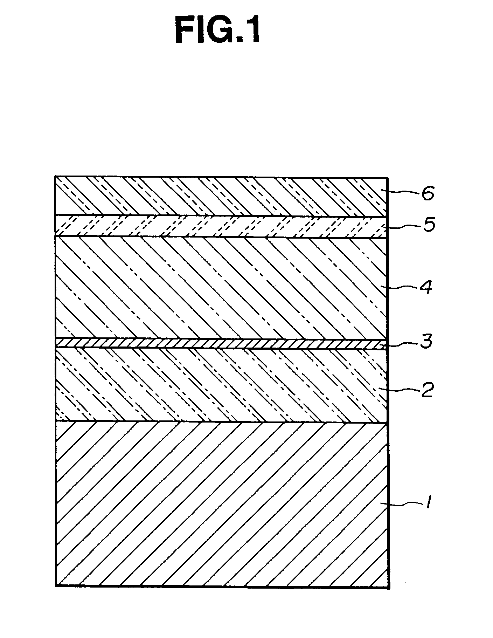

An undoped double heterostructure (DH structure) was produced according to the MOCVD technique as shown in Fig. 1. First, GaAs crystal 2 was grown to a thickness of 0.5 µm to form a buffer layer on a GaAs (100) substrate 1. On this buffer layer was grown a 1.5 nm-thick AlAs film 3 to form a surface protective layer. Growth of the GaAs buffer layer and the AlAs film was carried out under the following conditions: temperature = 700°C, pressure = 10² hPa, V:III molar ratio = 50:1, growth rate = 2.0 µm/hr. On said protective layer 3 were grown successively a 0.5 µm-thick (Al_{0.7}Ga_{0.3})_{0.5}In_{0.5}P cladding 4, a 0.1µm-thick (Al_{0.7}Ga_{0.5})_{0.5}In_{0.5}P active layer 5 and a 0.2 µm-thick (Al_{0.7}Ga_{0.3})_{0.5}In_{0.5}P cladding 6, under the conditions of a temperature of 700°C, a pressure of 102 hPa, a V:III molar ratio of 450:1 and a growth rate of 1.0 µm/hr.

### Comparative Example 1

The same procedure as Example 1 was carried out except that no AlAs film 3 was provided.

The DH structure grown according to the method of the present invention generated an approximately 10 times stronger photoluminescence intensity than the DH structure formed according to the conventional crystal growth method (Comparative Example 1).

### Example 2

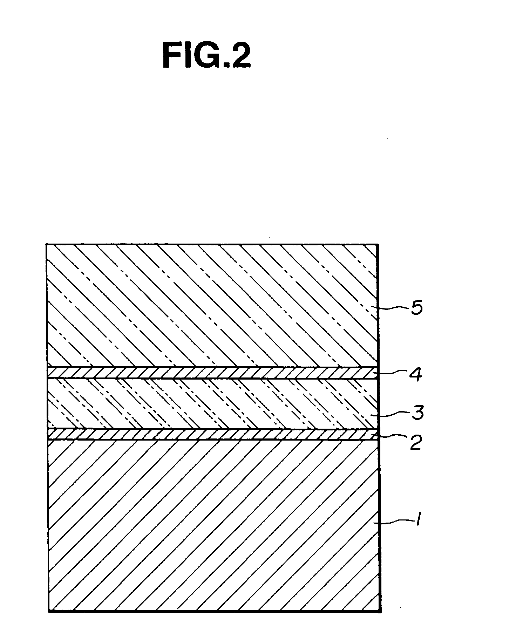

As shown in Fig. 2, a 1.5 nm-thick AlAs film 2 was grown to form a surface protective layer on a GaAs (100) substrate 1 according to the MOVPE technique under the conditions of a temperature of 660°C, a pressure of 10² hPa, a V:III molar ratio of 50:1 and a growth time of 7 seconds. On this surface protective layer a Ga_{0.5}In_{0.5}P crystal 3 was grown at a temperature of 660°C to a thickness of 0.2 µm to form a buffer layer on the AlAs film 2 under the conditions of a pressure of 10² hPa, a V:III molar ratio of 450:1 and a growth rate of 1.0 µm/hr. On this buffer layer 3 was grown a 1.5 nm thick AlAs film 4 at a temperature of 660°C to form a surface protective layer under the conditions of a pressure of 10² hPa, a V:III molar ratio of 50:1 and a growth time of 7 seconds. Then the temperature was raised at a rate of 5°C/min till it reached 700°C. As the gas atmosphere during heating, hydrogen gas was flowed along with A₅H₃ gas at 10 vol% based on hydrogen gas for preventing release of the As from the AlAs. Then (Al_{0.5}Ga_{0.5})_{0.5}In_{0.5}P crystal 5 was grown to a thickness of 0.5 µm under the conditions of a temperature of 700°C, a pressure of 10² hPa, a V:III molar ratio of 450:1 and a growth rate of 1.0 µm/hr.

### Comparative Example 2

(Al_{0.5}Ga_{0.5})_{0.5}In_{0.5}P sample structure was grown by following the procedure of Example 2 except that no AlAs film 3 was provided.

The sample structure provided with the AlAs layer generated about a 10-fold stronger photoluminescence intensity than the sample structure having no AlAs layer.

## Claims

1. A process for producing a Group III-V compound semiconductor, which comprises:
(1) forming a thin crystal film of A₁^{III}As_{w}P_{1-w}, wherein A₁^{III} represents one or more Group III elements with an Al content of less than 0.3, and 0.5 < w ≤ 1, on a semiconductor crystal substrate or on an epitaxial film grown on said substrate;
forming thereon a thin crystal film of B^{III}As, wherein B^{III} represents one or more Group III elements with an Al content of not less than 0.3; and
forming thereon a thin crystal film of C₁^{III}AsₓP₁₋ₓ, wherein C₁^{III} represents one or more Group III elements with an Al content of less than 0.3, and 0 ≤ x < 0.5; or
(2) forming a thin crystal film of A₂^{III}AsᵤP₁₋ᵤ, wherein A₂^{III} represents one or more Group III elements with an In content of not less than 0.3, and 0 ≤ u ≤ 1, on a semiconductor crystal substrate or on an epitaxial film grown on said substrate;
forming thereon a thin crystal film of B^{III}As, wherein B^{III} represents one or more Group III elements with an Al content of not less than 0.3; and
forming thereon a thin crystal film of C₂^{III}As_{z}P_{1-z}, wherein C₂^{III} represents one or more Group III elements and 0 ≤ z ≤ 1.

2. A process according to claim 1 wherein the Group III element is at least one element selected from Al, Ga and In.

3. A Group III-V compound semiconductor comprising:
(1) a thin crystal film of A₁^{III}As_{w}P_{1-w}, wherein A₁^{III} represents one or more Group III elements with an Al content of less than 0.3, and 0.5 < w ≤ 1, formed on a semiconductor crystal substrate or on an epitaxial film grown on said substrate;
a thin crystal film of B^{III}As, wherein B^{III} represents one or more Group III elements with an Al content of not less than 0.3, formed on the A₁^{III}As_{w}P_{1-w} film; and
a thin film of C₁^{III}AsₓP₁₋ₓ, wherein C₁^{III} represents one or more Group III elements with an Al content of less than 0.3, and 0 ≤ x < 0.5, formed on the B^{III}As film; or
(2) a thin film of A₂^{III}AsᵤP₁₋ᵤ, wherein A₂^{III} represents one or more Group III elements with an In content of not less than 0.3, and 0 ≤ u ≤ 1, formed on a semiconductor crystal substrate or on an epitaxial film grown on the said substrate;
a thin crystal film of B^{III}As, wherein B^{III} represents one or more Group III elements with an Al content of not less than 0.3, formed on the A₂^{III}AsᵤP₁₋ᵤ film; and
a thin film of C₂^{III}As_{z}P_{1-z}, wherein C₂^{III} represents one or more Group III elements, and 0 ≤ z ≤ 1, formed on the B^{III}As film.

4. A semiconductor according to claim 3 wherein the thickness of the thin crystal film of B^{III}As is 0.5 nm to 10µm.

5. A semiconductor according to claim 4 wherein the thickness of the thin crystal film of B^{III}As is 2 nm to 5µm.

6. A semiconductor according to any one of claims 3 to 5 wherein the Group III element is at least one element selected from Al, Ga and In.

7. A semiconductor according to claim 6 wherein B^{III}As is AlGaAs or AlAs.

8. A semiconductor according to any one of claims 3 to 7 which is obtainable by the process of claim 1.

9. A laser diode, light-emitting diode or transistor comprising a semiconductor as defined in any one of claims 3 to 7.

## Patentansprüche

1. Verfahren zur Herstellung eines Halbleiters aus Verbindungen der Gruppe III-V, umfassend:
(1) Bildung eines dünnen Kristallfilms von A₁^{III}As_{w}P_{1-w}, wobei A₁^{III} für ein oder mehrere Elemente der Gruppe III mit einem Al-Gehalt von weniger als 0,3 steht und 0,5 < w ≤ 1, auf einem Halbleiterkristallsubstrat oder einem auf dem genannten Substrat gezüchteten epitaxialen Film;
Bildung darauf eines dünnen Kristallfilms von B^{III}As, wobei B^{III} für ein oder mehrere Elemente der Gruppe III mit einem Al-Gehalt von nicht weniger als 0,3 steht; und
Bildung darauf eines dünnen Kristallfilms von C₁^{III}AsₓP₁₋ₓ, worin C₁^{III} für ein oder mehrere Elemente der Gruppe III mit einem Al-Gehalt von weniger als 0,3 steht und C ≤ x < 0,5, oder
(2) Bildung eines dünnen Kristallfilms von A₂^{III}AsᵤP₁₋ᵤ, wobei A₂^{III} für ein oder mehrere Elemente der Gruppe III mit einem In-Gehalt von nicht weniger als 0,3 steht und 0 ≤ u ≤ 1, auf einem Halbleiterkristallsubstrat oder einem auf dem genannten Substrat gezüchteten epitaxialen Film;
Bildung darauf eines dünnen Kristallfilms von B^{III}As, wobei B^{III} für ein oder mehrere Elemente der Gruppe III mit einem Al-Gehalt von nicht weniger als 0,3 steht; und
Bildung darauf eines dünnen Kristallfilms von C₂^{III}As_{z}P_{1-z}, wobei C₂^{III} für ein oder mehrere Elemente der Gruppe III steht und 0 ≤ z ≤ 1.

2. Verfahren nach Anspruch 1, dadurch **gekennzeichnet,** daß das Element der Gruppe III mindestens ein Element, ausgewählt aus Al, Ga und In, ist.

3. Halbleiter aus Verbindungen der Gruppe III-V, umfassend:
(1) einen dünnen Kristallfilm von A₁^{III}As_{w}P_{1-w}, wobei A₁^{III} für ein oder mehrere Elemente der Gruppe III mit einem Al-Gehalt von weniger als 0,3 steht und 0,5 < w ≤ 1, der auf einem Halbleiterkristallsubstrat oder einem auf dem genannten Substrat gezüchteten epitaxialen Film gebildet ist;
einen dünnen Kristallfilm von B^{III}As, wobei B^{III} für ein oder mehrere Elemente der Gruppe III mit einem Al-Gehalt von nicht weniger als 0,3 steht, der auf dem A₁^{III}As_{w}P_{1-w}-Film gebildet ist; und
einen dünnen Film von C₁^{III}AsₓP₁₋ₓ, worin C₁^{III} für ein oder mehrere Elemente der Gruppe III mit einem Al-Gehalt von weniger als 0,3 steht und 0 ≤ x < 0,5, der auf dem B^{III}As-Film gebildet ist; oder
(2) einen dünnen Film von A₂^{III}AsᵤP₁₋ᵤ, wobei A₂^{III} für ein oder mehrere Elemente der Gruppe III mit einem In-GehalL von nicht weniger als 0,3 steht und 0 ≤ u ≤ 1, der auf einem Halbleiterkristallsubstrat oder einem auf dem genannten Substrat gezüchteten epitaxialen Film gebildet ist;
einen dünnen Kristallfilm von B^{III}As, wobei B^{III} für ein oder mehrere Elemente der Gruppe III mit einem Al-Ge-halt von nicht weniger als 0,3 steht, der auf dem A₂^{III}AsᵤP₁₋ᵤ-Film gebildet ist; und
einen dünnen Film von C₂^{III}As_{z}P_{1-z}, wobei C₂^{III} für ein oder mehrere Elemente der Gruppe III steht und 0 ≤ z ≤ 1, der auf dem B^{III}As-Film gebildet ist.

4. Halbleiter nach Anspruch 3, dadurch **gekennzeichnet,** daß die Dicke des dünnen Kristallfilms von B^{III}As 0,5 nm bis 10 µm beträgt.

5. Halbleiter nach Anspruch 4, dadurch **gekennzeichnet,** daß die Dicke des dünnen Kristallfilms von B^{III}As 2 nm bis 5 µm beträgt.

6. Halbleiter nach einem der Ansprüche 3 bis 5, dadurch **gekennzeichnet,** daß das Element der Gruppe III mindestens ein Element, ausgewählt aus Al, Ga und in, ist.

7. Halbleiter nach Anspruch 6, dadurch **gekennzeichnet,** daß B^{III}As AlGaAs oder AlAs ist.

8. Halbleiter nach einem der Ansprüche 3 bis 7, erhältlich durch das Verfahren nach Anspruch 1.

9. Laserdiode, lichtemittierende Diode oder Transistor, umfassend einen Halbleiter nach einem der Ansprüche 3 bis 7.

## Revendications

1. Procédé de fabrication d'un semi-conducteur composite du groupe III-V, comprenant les étapes suivantes ;
(1) on forme un film mince de cristal de A₁^{III}As_{w}P_{1-w}, dans lequel A₁^{III} représente un ou plusieurs éléments du groupe III avec une teneur en Al de moins de 0,3, et 0,5< w ≤ 1, sur un substrat de cristal semi-conducteur ou un film épitaxial crû sur ledit substrat,
on forme là-dessus un film mince de cristal B^{III}As, dans lequel B^{III} représente un ou plusieurs éléments du groupe III avec une teneur en Al qui n'est pas inférieur à 0,3, et
on forme là-dessus un film mince de cristal de C₁^{III}AsₓP₁₋ₓ, dans lequel C₁^{III} représente un ou plusieurs éléments du groupe III avec une teneur en Al de moins de 0,3 et 0≤ x < 0,5, ou
(2) on forme un film mince de cristal de A₂^{III}AsᵤP₁₋ᵤ, dans lequel A₂^{III} représente un ou plusieurs éléments du groupe III avec une teneur en In qui n'est pas inférieur à 0,3 et 0 ≤ u ≤ 1, sur un substrat de cristal semi-conducteur ou un film épitaxial crû sur ledit substrat,
on forme là-dessus un film mince de cristal de B^{III}As, dans lequel B^{III} représente un ou plusieurs éléments du groupe III avec une teneur en Al qui n'est pas inférieur à 0,3, et
on forme là-dessus un film mince de cristal de C₂^{III}As_{z}P_{1-z}, dans lequel C₂^{III} représente un ou plusieurs éléments du groupe III et 0 ≤ z ≤1.

2. Procédé selon la revendication 1 dans lequel l'élément du groupe III est au moins un des éléments choisis parmi Al, Ga et In.

3. Semi-conducteur composite du groupe III-V, comprenant :
(1) un film mince de cristal de A₁^{III}As_{w}P_{1-w}, dans lequel A₁^{III} représente un ou plusieurs éléments du groupe III avec une teneur en Al de moins de 0,3, et 0,5< w ≤ 1, sur un substrat de cristal semi-conducteur ou un film épitaxial crû sur ledit substrat,
un film mince de cristal B^{III}As, dans lequel B^{III} représente un ou plusieurs éléments du groupe III avec une teneur en Al qui n'est pas inférieur à 0,3, et
un film mince de cristal de C₁^{III}AsₓP₁₋ₓ, dans lequel C₁^{III} représente un ou plusieurs éléments du groupe III avec une teneur en Al de moins de 0,3 et 0≤ x < 0,5, ou
(2) un film mince de cristal de A₂^{III}AsᵤP₁₋ᵤ, dans lequel A₂^{III} représente un ou plusieurs éléments du groupe III avec une teneur en In qui n'est pas inférieur à 0,3 et 0 ≤ u ≤ 1, sur un substrat de cristal semi-conducteur ou un film épitaxial crû sur ledit substrat,
un film mince de cristal de B"'As, dans lequel B^{III} représente un ou plusieurs éléments du groupe III avec une teneur en Al qui n'est pas inférieur à 0,3, et
un film mince de cristal de C₂^{III}As_{z}P_{1-z}, dans lequel C₂^{III} représente un ou plusieurs éléments du groupe III et 0 ≤ z ≤1.

4. Semi-conducteur selon la revendication 3, dans lequel l'épaisseur du film mince de cristal de B^{III}As est compris entre 0,5 nm et 10µm.

5. Semi-conducteur selon la revendication 4, dans lequel l'épaisseur du film mince de cristal de B^{III}As est compris entre 2nm et 5µm.

6. Semi-conducteur selon l'une quelconque des revendications 3 à 5, dans lequel l'élément de groupe III est au moins un des éléments choisis parmi Al, Ga et In.

7. Semi-conducteur selon la revendication 6, dans lequel B^{III}As est AlGaAs ou AlAs.

8. Semi-conducteur selon l'une quelconque des revendications 3 à 7 pouvant être obtenu par le procédé de la revendication 1.

9. Diode laser, diode-émettrice de lumière ou transistor comprenant un semi-conducteur tel que défini dans l'une quelconque des revendications 3 à 7.
